(19) Europäisches Patentamt
European Patent Office
Office européen des brevets

(11) **EP 2 210 147 B1**

(12) **EUROPEAN PATENT SPECIFICATION**

(45) Date of publication and mention
of the grant of the patent:
**22.05.2013 Bulletin 2013/21**

(51) Int Cl.:
*G03F 7/20* (2006.01)    *G21K 1/06* (2006.01)
*G02B 5/08* (2006.01)

(21) Application number: **07820858.4**

(22) Date of filing: **02.10.2007**

(86) International application number:
**PCT/EP2007/060477**

(87) International publication number:
**WO 2009/043374 (09.04.2009 Gazette 2009/15)**

(54) **APERIODIC MULTILAYER STRUCTURES**

APERIODISCHE MEHRSCHICHTSTRUKTUREN

STRUCTURES MULTICOUCHES APÉRIODIQUES

(84) Designated Contracting States:
**AT BE BG CH CY CZ DE DK EE ES FI FR GB GR
HU IE IS IT LI LT LU LV MC MT NL PL PT RO SE
SI SK TR**

(43) Date of publication of application:
**28.07.2010 Bulletin 2010/30**

(73) Proprietors:
• **Universita Degli Studi Di Padova**
**35122 Padova (IT)**
• **Consiglio Nazionale Delle Ricerche**
**00185 Roma (IT)**

(72) Inventors:
• **PELIZZO, Maria-Guglielmina**
**35128 Padova (IT)**
• **NICOLOSI, Piergiorgio**
**35020 Legnaro (Padova) (IT)**
• **SUMAN, Michele**
**31050 Onigo Di Pederobba (Treviso) (IT)**
• **WINDT, David L.**
**New York, NY 10025 (US)**

(74) Representative: **Vanzini, Christian**
**Jacobacci & Partners S.p.A.**
**Corso Emilia 8**
**10152 Torino (IT)**

(56) References cited:
WO-A-2006/066563    US-A1- 2004 253 426
US-A1- 2005 031 071    US-A1- 2006 066 940

• **DOBROWOLSKI J A ET AL: "REFINEMENT OF OPTICAL MULTILAYER SYSTEMS WITH DIFFERENT OPTIMIZATION PROCEDURES" APPLIED OPTICS, OSA, OPTICAL SOCIETY OF AMERICA, WASHINGTON, DC, vol. 29, no. 19, 1 July 1990 (1990-07-01), pages 2876-2893, XP000135714 ISSN: 0003-6935**
• **SOFT X-RAY AND EUV IMAGING SYSTEMS 3-4 AUG. 2000 SAN DIEGO, CA, USA, vol. 4146, 1 November 2000 (2000-11-01), pages 83-90, XP002491918 Proceedings of the SPIE - The International Society for Optical Engineering SPIE-Int. Soc. Opt. Eng USA ISSN: 0277-786X & DATABASE INSPEC [Online] THE INSTITUTION OF ELECTRICAL ENGINEERS, STEVENAGE, GB; 2000, ZHANSHAN WANG ET AL: "Design, fabrication, and characterization of broadband multilayer mirrors for EUV optics at normal incidence" Database accession no. 6993047**

**Description**

The present invention refers reflective coatings including multilayer aperiodic structures covered by protective capping layers meant for use as reflective coatings for extreme ultraviolet radiation (EUV), particularly in photolithographic processes, as defined in the preamble of claim 1.

High normal incidence reflectivity of a source spectrum in the EUV and soft X-ray spectral range can be obtained only with multilayer structures designed so that the electric field components reflected at the various interfaces can add in phase; in fact, conventional single layer coatings provide negligible reflectance.

The multilayer structures used for EUV lithography (EUVL) in particular typically consist of alternating layers of different materials, for example Molybdenum and amorphous Silicon or Molybdenum and Beryllium (Paul B. Mirkarimi, Sasa Bajt et al. "Mo/Si and Mo/Be multilayer thin films on Zerodur substrates for extreme-ultraviolet lithography", Applied Optics Vol. 39(10), pp. 1617-1625, 2000). High reflectivity is crucial for photolithographic applications, since the throughput of the system (i.e., number of patterned wafers per hour) depends critically on the intensity of the radiation beam used to project the image of a mask on the photo-resist-coated wafer. Since the optical system typically consists of 9-10 reflective elements, it is clear how even a very small change of the reflectivity of the coating can affect significantly its final performances.

A typical multilayer structure used in EUV photolithography is made of a periodic repetition of a pair of materials, for example Molybdenum and amorphous Silicon, for peak reflectivity near 13.5nm. A typical periodic structure has a period of about 7 nm, and a $\Gamma$ value of about 0.6, where $\Gamma$ is the ratio between the thickness of the Silicon layer and the multilayer period.

The use of a thin interlayer of a different material, for example $B_4C$, is a well established technique that can be used to avoid interdiffusion and formation of oxide at the interfaces. Peak reflectivity of approximately 70% has been obtained using $B_4C$ interlayers (Sasa Bajt, Jennifer B. Alameda et al. "Improved reflectance and stability of Mo/Si multilayers", Optical Engineering 41(08), p. 1797-1804, Donald C. O'Shea; Ed., 2002), compared with 68-69% peak reflectance obtained in multilayers without any $B_4C$ interlayers.

Another important key element of these structures is the capping layer. In a basic Molybdenum/Silicon multilayer, the highest peak reflectivity is obtained if the last layer is Molybdenum. However, this Molybdenum layer oxidizes in air and the formation of an oxide top surface degrades the peak reflectivity considerably (Underwood et al, Applied Optics 32, p. 6985, 1993). Therefore Silicon is preferred as capping layer, since, after forming an oxide film, it becomes stable over time. Different environmental effects can affect multilayer performance; in photolithographic apparatus, for example, the coating is exposed to high stress environmental conditions (presence of debris, contaminants, water vapour). For this reason, a protective layer of another material must be deposited on top of the structure. Unfortunately, the deposition of an additional protective capping layer structure on top of the multilayer, as those proved being stable and effective in harsh environments, can reduce the reflectivity as well. Even a small reduction of 1% absolute value of peak reflectivity means a final reduction of more than 18% of the total throughput for a ten elements (ten reflections) system.

When the EUV radiation interacts with a multilayer structure, the superposition of the incident and reflected electromagnetic wave generates a standing wave field distribution in the multilayer structure. In the case of periodic Silicon-Molybdenum multilayer with a last layer of Silicon, a standing wave node appears at the vacuum interface. If on top of the structure a typical capping layer is deposited, the maximum of the standing wave is placed inside the capping layer itself and the radiation is strongly weakened. Consequently less internal layers contribute to the building up of the reflected wave, affecting its intensity. Moreover, the fact that the capping layer absorbs an high amount of radiation increase the oxidation process of the capping layer itself.

The design of a periodic multilayer structure such as those described above doesn't take into account the full effect of the complex phase of the electric field at each interface in the stack. It has been so proposed by Masaki Yamamoto and Takeshi Namioka the use of aperiodic multilayer structures ("Layer-by-layer design method for soft-X-rays multi layers", Applied Optics, Vol. 31, No. 10, pp.1622-1630, 1992). In this paper an analytical method effective for the design of soft-X-rays multilayers has been presented. The design is carried on by the aid of the graphic representation of the complex amplitude reflectance in a Gaussian plane.

In past works, aperiodic structures have been designed first to offer best performance in term of peak reflectivity and the incorporation of a capping layer was considered subsequently. By using this approach, solutions have not always offered significantly higher performance with respect to periodic structures: for example the performance of a periodic or an aperiodic multilayer structure with an a-$SiO_2$ capping layer are quite similar.

Only more recently has the need to protect the structure by a resistant capping layer lead to the optimization of the structure as a whole. Some commercial tools are available to optimize thin layer structures, as for example TFCalc (M. Singh, J. M. Braat, "Design of multilayer extreme - ultraviolet mirrors for enhanced reflectivity", Applied Optics Vol. 39, No.13, p.2189, 2000 and EP 1065532 A2 and US6724462 B1). TFCalc can allow optimization of some parameters of the structures using a global optimization procedure, but only by assuming ideally smooth interfaces. Aperiodic Molybdenum/amorphous Silicon solutions, within possibly the insertion of a third needle layer, have been optimized under some proposed capping layers. In the proposed design typical thickness of the capping layers considered are of the order of 1.5-1.7 nm and last layer under the capping is amorphous Silicon. In the case of a two component Molybdenum/ amorphous Silicon multilayer (without the needle layer) the optimization results in a gradual, smooth variation of the layer thickness of the two materials, while the period remains constant, around 7 nm.

Different possible materials can be in principle selected as capping layer for aperiodic structures if the choice is based on the refractive index properties (M. Singh and J. J. M. Braat, "Capping layers for extreme ultraviolet multilayer interference coatings," Opt. Lett. 26, pp. 259-261, 2001 and US6724462 B1). However, in addition to optical properties requirements, capping layer materials need to meet additional criteria for acceptable performance, as stated above. In particular, they have not to inter-diffuse with the material underneath and they have to be oxidation resistant in a water-vapor environment.

Oxidation of multilayer structures in a photo-lithographic apparatus is mainly due to the presence of water vapor. The oxidation depends on the interaction between EUV photons and the multilayer material (Sasa Bajt, Zu Rong Dai et al. "Oxidation resistance of Ru-capped EUV multilayers" Proc. SPIE Vol. 5751, p. 118-127, Emerging Lithographic Technologies IX; R. Scott Mackay, 2005). The use of an oxidation-resistant protective capping layer is therefore necessary. Ruthenium, which form $RuO_2$ on top, is the material identified as having the best performance thus far in this regard. Unfortunately, Ruthenium deposited directly on Silicon has been discovered to be unstable, interdiffusing with Silicon and forming Ruthenium Silicide (Sasa Bajt, Henry N. Chapman et. al "Design and performance of capping layers for extreme-ultraviolet multilayer mirrors", Applied Optics 42(28), pp.5750-5758, 2003).

Innovative capping layers consisting of two layers have been proposed in US 6780 496 B2. A top layer protects the structures from the environment, while the second one acts as a diffusion barrier between the top of the multilayer structure beneath. Material combinations considered include $Ru/B_4C$ and Ru/Mo. Structures with Ruthenium layers thicker than 2.3nm have been demonstrated to be quite stable against environmental agents (Sasa Bajt, Jennifer B. Alameda, et al. "Improved reflectance and stability of Mo/Si multilayers", Optical Engineering 41(08), p. 1797-1804, Donald C. O'Shea; Ed., 2002).

WO 2006/066563 discloses a multilayer coating for the EUV spectral region. The multilayer structure of such coating may have an aperiodicity distributed in all the layer thicknesses.

US 2004/253426 discloses a multilayer coating according to the preamble of claim 1. The layer materials and/or layer thicknesses of such coating are selected such that a standing wave which forms during reflection of the irradiated operating wavelength, forms a node of the electrical field strength in an area of a free interface of the multilayer system.

US 2005/031071 discloses an X-ray multilayer mirror including an Mo/Si alternate layer with a non-uniform film thickness structure.

The publication of Dobrowolski J. A. et al.: "Refinement of optical multilayer systems with different optimization procedures" (Applied Optics, vol. 29, no. 19, 1 July 1990, pages 2876-2893) discloses, among others, an adaptive random search procedure for refinement of optical multilayer systems (page 2879).

The publication of Zhanshan Wang et al.: "Design, fabrication, and characterization of broadband multilayer mirrors for EUV optics at normal incidence" (Soft X-ray and EUV imaging systems, Proceedings of SPIE, vol. 4146, 1 November 2000, pages 83-90) discloses a method of designing multilayers with broadband wavelength responses for use as coatings in EUV optics at normal incidence.

US2006/066940 discloses a periodic multilayer coating. The thickness of a capping layer is selected such that a standing wave, which forms during reflection of radiation having an operating wavelength, forms a node of the electrical field which, due to carbon contamination of the capping layer, may shift inside the capping layer.

One object of the present invention is to propose innovative reflective coatings including aperiodic multilayer structures which provide improved flux performance in photolithography or in another optical apparatus and which have a reduced sensibility of reflectivity performances to oxidation or contamination of capping layers so that experimental realized structures have life-time performances closer to theoretical. The proposed structures have furthermore improved reflectivity performances stability to layer thickness errors occurring during deposition and are less sensitive to the capping layer materials optical properties.

Another object is to provide an aperiodic multilayer structure design method for designing such structures which allows to obtain a best peak reflectivity (one or more reflections), a large spectral band (one or more reflections) and a match with spectral source distribution (one or more reflections).

These and other objects are achieved according to the invention with reflective coating as defined in claim 1 and a design method as defined in claim 12. Specific embodiments are defined in the dependent claims.

A specific embodiment of the invention consists of aperiodic multilayer structures which have an aperiodicity distributed randomly in all the layer thicknesses. In this context the term randomly is intended to mean that the values of the thicknesses can not be described by or do not follow any particular order or trend. Preferably, the aperiodicity is distributed in all the layer thicknesses, alternatively, the aperiodicity is limited to the layers of the last period underneath the capping layer.

The optimization of structure with only the layers underneath the capping layer varied is made only to achieve best peak reflectivity, while the ones in which the aperiodicity is distributed in all the layer thicknesses is made to maximize total photon flux according to different optical apparatus. In any case, aperiodic structures with randomly distributed layer thicknesses through all the stack offer better performances, as shown later in the examples.

The structures are made of two or more materials (preferably Molybdenum and amorphous Silicon) and include protective capping layers for best performances in EUV lithography applications. Preferably, different interlayer materials, for example $B_4C$, are included to prevent interdiffusion.

The design optimization of the aperiodic multilayer structures is dependent on the presence of the capping layer. First the capping layer properties such as layer thickness and materials are defined for maximum performance, then the multilayer structure is optimized. In order to guarantee feasibility of the structure according to recent studies on capping layers, structures with most perfoming capping layers of Mo/Ru and $B_4C$/Ru have been considered specifically, but the invention is not limited to these specific capping layer prescriptions. Indeed, because the aperiodic design optimization results in greatly relaxed optical properties requirements for the capping layer, other materials and material combinations that eventually show even greater protection than Mo/Ru and $B_4C$/Ru can be utilized.

The new multilayer designs result in very interesting properties:

1) They provide improved flux performance in a photolithography or in another optical apparatus. This is due to two main facts:

- the energy absorption in the top layers of the multilayer is reduced, therefore the EUV signal penetrates deeper into the structure and more layers can contribute to the final reflectivity;
- in case of multilayers with aperiodicity distributed randomly through the all stack, the optimization of layers thickness allows a further increasing of the amplitude of the reflected field. In fact interference among interfaces reflected components is further improved by optimizing multiple reflections contribution inside each layer.

2) The absorption of the EUV in the top layers of the multilayer is reduced, therefore also the mechanism of oxidation formation is slowed down.

3) The multilayer structure is less sensitive to the capping layer materials, i.e. its performance is nearly independent on the choice of capping layer optical properties. This means also that if there is a change of the optical constants of the top layer, for example due to contamination or oxidation, the performance remains unchanged.

4) Since the absorption of top layers is reduced the energy can penetrate deeper in the multilayer structure and consequently it will be distributed in a larger volume with less density, accordingly reducing the induced thermal stress.

5) Multilayers have an improved stability of performances with respect to possible layer thickness errors occurring during deposition.

All aspects 2-4 increase the lifetime of the multilayer structure.

Further characteristics and advantages of the invention will be made clear by the following detailed description, provided purely by way of non-limiting example, with reference to the attached drawings, in which:

- figure 1 is a schematic sectional view of last final layers of a first aperiodic multilayer structure according to the invention;
- figure 2 is a schematic view of last final layers of a second aperiodic multilayer structure according to the invention;
- figure 3 is a graphic of the experimental reflectance of the structure of figure 1 for two different capping layer materials;
- figure 4 is a schematic sectional view of a multilayer structure;
- figure 5 is a scheme of a spherical domain;
- figure 6 is a schematic sectional view of a conical sub-domain with respect to the one of figure 5;
- figure 7 is a graphic of the thicknesses of the layer of a possible structure according to the invention;
- figure 8 is a graph of the experimental reflectance for two different structures;
- figure 9 is a graph of the throughput a projection system;
- figure 10 is a graphic of the intensity value of a node out of the capping layer;
- figure 11 is a graphic of the peak reflectivity as a function of the oxidation of the capping layer; and
- figure 12 are two graphs of the percentage of reflected spectrum for two different structures.

The superposition of the incident and reflected electromagnetic wave results in a standing wave field distribution in the multilayer structure, as previously stated. The structures according to the invention are characterized by the property that the capping layer is spatially shifted with respect to the position of the standing-wave anti-node at the top of the multilayer, while providing best reflectance performances, as described later. In particular, a deep analysis of the standing wave field distribution inside the multilayer itself shows that the solutions founded are the best compromise between the two following characteristics:

- at working wavelength, the standing wave field strength is minimized in the capping layer (i.e. the absorbed energy is minimized);
- the standing wave field is distributed to maximize reflectivity performances; this is equivalent to minimize the first node of the standing wave outside the multilayer.

Moreover, the properties remain valid not only at one wavelength but they extend over the full spectral range of the source in case of the structures having a randomly distributed layer thicknesses made, for example, to match a source spectrum in a photolithographic apparatus or to have a large spectral band.

For example, in case of a photolithographic apparatus with a Sn plasma laser source and ten reflections, an improved flux more then two times with respect to standard coating is achievable, while resistance to the environmental attach is guaranteed by the use of most reliable capping layers.

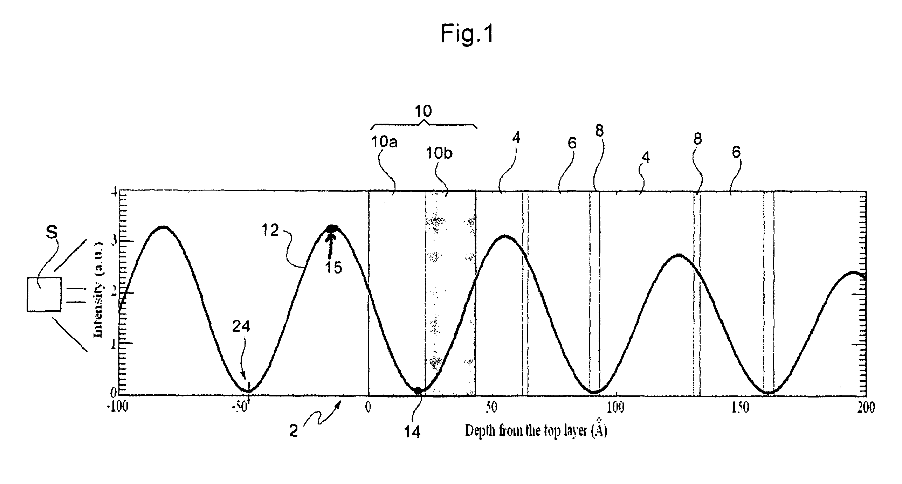

Figure 1 shows a schematic section of a multilayer stack 2 made of two alternating layers of different material, a layer of a first material 4 and a layer of a second material 6. Interlayers 8 are included between the layer of the first 4 and the second 6 material to prevent inter-diffusion.

The first material 4 is for example amorphous Silicon, the second material 6 is Molybdenum and the interlayers 8 are of $B_4C$.

Further examples of first 4 and second 6 material may include Beryllium, Ruthenium, Rhodium, Strontium and similar materials or their compounds.

Further examples of interlayers 8 may include Carbon and Silicon Carbide and similar materials or compounds.

In an alternative embodiment, interlayers 8 are omitted so that the stack 2 is made only of the first 4 and second 6 material.

On the top of the stack 2 is deposited a capping layer 10, which comprises for example a first layer 10a of Ruthenium and a second layer 10b of $B_4C$. Alternatively, the capping layer 10 may be made of a single material.

Further examples of capping layer materials may include Ruthenium, Rhodium, Zirconium, Palladium, Platinum, Osmium, Iridium used alone or combined for example with a layer of Boron Carbide, Carbon, Silicon Carbide, Molybdenum and similar materials, used as pure elements or compounds.

The layers of the first 4 and the second 6 material present thicknesses which vary each other in a random way through the whole stack 2, realizing an aperiodic structure.

The capping layer 10 is illuminated by radiation coming from a source S, for example a Sn laser produced plasma source or another optical element that redirects the source beam, placed in front of the capping layer 10.

The capping layer 10 is spatially shifted with respect to the position of the standing-wave anti-node at the top of the stack 2, as can be seen from figure 1 which shows a standing wave 12 which has a node 14 in the capping layer 10 and an anti-node 15 out of the capping layer so that the stack 2 offers superior efficiency performances and is substantially insensitive to the capping layer materials optical properties.

The standing wave field at working wavelengths is thus shifted in the capping layer with respect to the periodic multilayer structures of the prior art in order to minimize the absorbed energy in the first layers. The energy absorption in the top layers of the multilayer stack 2 is reduced, therefore the EUV signal penetrates deeper into the structure and therefore more layers can contribute to the final reflectivity. Due to this property, the thermal stress is also reduced, since the energy is distributed over more layers. Furthermore, the oxidation process of the capping layer 10 is slowed down due to the fact that capping layer 10 absorbs less EUV light which is responsible for the creation of secondary electrons that lead to oxidation. Moreover, the random distribution of the layers of the first 4 and second 6 materials make them less sensitive to thickness errors during deposition, as demonstrated later.

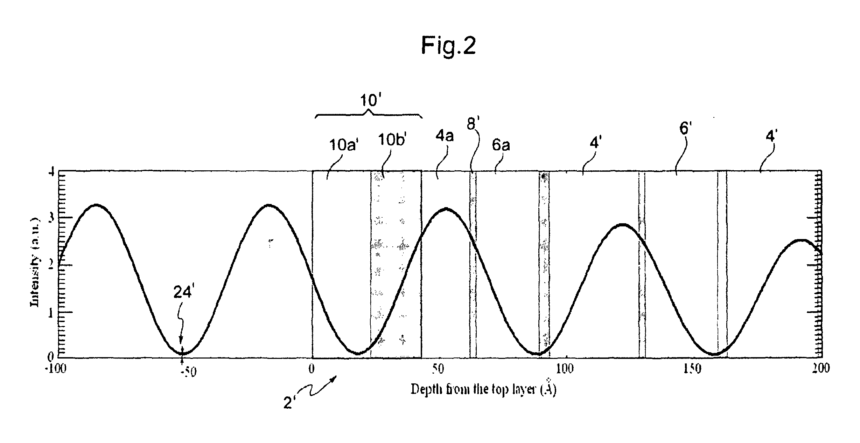

Figure 2 shows a schematic sectional view of a second embodiment of the multilayer structure according to the invention. A stack 2' is made of two alternating layers of a first material 4' and a second material 6' with interlayers 8' included between the layer of the first 4' and the second 6' material to prevent inter-diffusion..

The first material 4' is for example amorphous Silicon, the second material 6' is Molybdenum and the interlayers 8' are of $B_4C$.

In an alternative embodiment, interlayers 8' are omitted so that the stack 2' is made only of the first 4' and second 6' material.

On the top of the stack is deposited a capping layer 10' which comprises for example a first layer 10a' of Ruthenium and a second layer 10b' of $B_4C$. Alternatively, the capping layer 10' may be made of a single material.

The first layer of the first material under the capping layer 10' is indicated 4a; the first layer of the second material under the capping layer 10' is indicated 6a. Layers 4a and 6a are indicated together as pre-caplayer. These layers 4a and 6a have a thickness different from the thickness of respective layers of the first 4' and second 6' material, which realize a periodic structure through the whole stack 2'.

Useful materials are the same as listed with reference to the stack 2 of figure 1. Performances are generally lower than those of previous structure according to figure 1. Moreover, stability of solution with respect to layer thickness errors is lower. Therefore, advantageously, these solutions have a more simple design, requiring less optimization parameters.

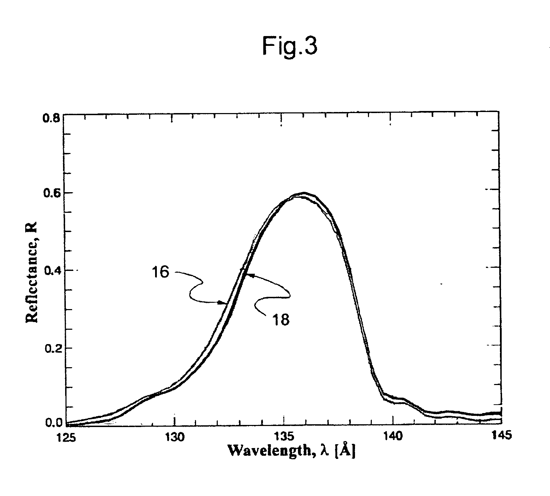

In figure 3 are shown two experimental curves of the reflectance of the aperiodic stack 2 (without the interlayers 8) as function of the wavelength of the incident radiation. A first curve 16 is related to the stack 2 with a capping layer 10 made of a first layer 10a of Platinum and a second layer 10b of Molybdenum, a second curve 18 is related to the stack 2 with a capping layer 10 made of a first layer 10a of Ruthenium and a second layer 10b of Molybdenum. As can be noted, the reflectance properties are essentially equivalent, according to what previously stated. Additionally, even if the capping layer gets oxidized or contaminated, the reflectivity performances are essentially unchanged.

For the design of the aperiodic structures with randomly distributed layer thicknesses above described, a new design method has been developed. The realization of the structures is made by defining a merit function accordingly, as for example $\int R(\lambda)^N * I(\lambda) d\lambda$, where $I(\lambda)$ is the source spectrum, $R(\lambda)$ is the reflectivity of the structure and N is number of mirrors in the apparatus (particularly 9 or 10). Other merit functions can also be used. The design method looks for the best solution defined in the space of the different multilayer structures. Considering that multilayer reflection r(f) depends very critically from its structural parameters, i.e. its performances are very sensitive to small variations of the multilayer structure, an "evolutive strategy" has been used. The "evolutive" approach differs from a local optimization algorithm, that would be improper since it would explore only a limited domain region, and from typical global optimizations, like a genetic algorithm, which would be too weak for focus towards a domain region with overconfidence. For this reason, the design method developed is able to acquire domain knowledge based on the merit function values during the optimization process. During the optimization, typical roughness values at the interfaces are also taken into account; this makes possible to find solutions having superior performances with respect to those solutions in which roughness is not taken into account. This type of optimization explores a wide interval in the space of solutions, taking into account all experimental aspects related to practical feasibility of the structure.

The method provide computation of the multilayer reflectance as well as of the whole merit function. Computation takes into account roughness at interfaces, inter-diffusion between layers, roughness at the substrate, and can include any other parameter related to a real deposited multilayer structure, differently from other used software, as TFCALC. The optical constants used for the calculation are those provide by the Center for X-Ray Optics database.

The design algorithm must focus toward a structure that maximize the merit function.

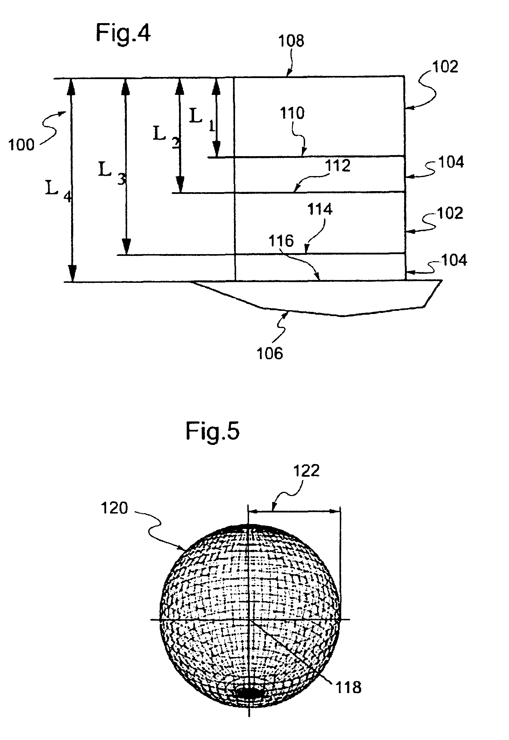

A generic multilayer composed by N layers is defined as $\bar{x} = \left( L_1^{\bar{x}}, L_2^{\bar{x}}, L_3^{\bar{x}}, L_4^{\bar{x}}, \ldots L_N^{\bar{x}} \right)$ where the $L_i^{\bar{x}}$ are the distance of the i-th interface from a top interface of the multilayer $\bar{x}$ in angstrom, as shown in figure 4. N is typically 110.

Figure 4 shows a multilayer structure 100 formed by alternating layers 102, 104 of different material, for example Silicon and Molybdenum, deposited on a substrate 106; the top interface of the multilayer x is indicated 108. $L_1$ is the distance of a first interface 110 from the top interface 108, $L_2$ is the distance of a second interface 112 from the top interface 108, $L_3$ is the distance of a third interface 114 from the top interface 108 and $L_4$ is the distance of a fourth interface 116 from the top interface 108.

The norm of $\bar{x}$ is:

$$\|\bar{x}\| = \sqrt{\sum_{i=1}^{N} \left( L_i^{\bar{x}} \right)^2}$$

and the distance between two different structures $\bar{x}_1$ and $\bar{x}_2$ is:

$$d(\bar{x}_1, \bar{x}_2) = \|\bar{x}_1 - \bar{x}_2\| = \sqrt{\sum_{i=1}^{N} \left( L_i^{\bar{x}_1} - L_i^{\bar{x}_2} \right)^2}$$

The firs step of the method according to the invention is the definition of a predetermined time interval into which execute said design method; preferably, said time interval is of eight hours for a home computer with a 3GHz processor. Then, a set of periodic multilayer structures is considered, particularly a family of 4 multilayer structures

$$\left\{ \bar{x}_1^{step=0}, \bar{x}_2^{step=0}, \bar{x}_3^{step=0}, \bar{x}_4^{step=0} \right\}$$ which have an optimized period value and a randomly defined r ratio. For each

multilayer structure $\bar{x}_i$ of said set a spherical domain $B\left(\bar{x}_i, \rho\right)$ centred in $\bar{x}_i \in B\left(\bar{xi}, \rho\right)$ is defined, where p is the radius of the sphere, in angstrom. Figure 5 shows a structure $x_i^{step=j}$ 118 and a spherical domain 120 having a radius 122; to visualize the concept, a tri-dimensional domain is represented.

In any successive j-th calculation step (j=1,2,3,....) a mutation $\zeta_i^j$ is applied to the structures $\bar{x}_i^{step=j}$. Mutations $\zeta_i^j\left(\bar{x}_i^{step=j}\right)$ are randomly chosen inside the proper domain $B\left(\bar{x}_{i=1,2,3,4}^{step=j}, \rho\right)$ associated to each multilayer structure $\bar{x}_i$. If an enhancement of the merit function is obtained, the mutation solution $\zeta_i^j\left(\bar{x}_i^{step=j}\right)$ swap the solution $\bar{x}_i^{step=j}$ in the population at the j+1-th step $\left(\bar{x}_i^{step=j+1} = \zeta_i^j\left(\bar{x}_i^{step=j}\right)\right)$ and a new spherical domain centred in the mutation solution $B\left(\bar{x}_i^{j+1}, \rho\right)$ is substituted for the spherical domain $B\left(\bar{x}_i, \rho\right)$. In the case that the merit function associated to one of the structures x has a value that exceeds a mean value of the merit functions of the family at the j+1-th step over a predetermined threshold, the spherical domain region where applying a mutation becomes a cone $C\left(\bar{x}^{step=j+1}, \rho, versor, \alpha\right)$ where:

- $\bar{x}_i^{step=j+1}$ is the central point,
- *versor* is the central axes determined by the formula:

$$versor = \frac{\left(\zeta_i^j(\bar{x}_i^j) - \bar{x}_i^j\right)}{d(\zeta_i^j(\bar{x}_i^j), \bar{x}_i^j)} \cdot \frac{MF\left(\zeta_i^j(\bar{x}_i^j)\right) - MF\left(\bar{x}_i^j\right)}{\left|MF\left(\zeta_i^j(\bar{x}_i^j)\right) - MF\left(\bar{x}_i^j\right)\right|}$$

where $MF\left(\bar{x}^{step=j}\right)$ is the merit function value of the multilayer $\bar{x}^{step=j}$ ;

- $\alpha$ is the angle in the vertex determined by:

$$\alpha = \frac{\left|MF\left(\zeta_i^j\left(\bar{x}_i^{step=j}\right)\right) - MF\left(\bar{x}_i^{step=j}\right)\right|}{\left|MF\left(\bar{x}_i^{step=j+1}\right) - \frac{\sum_{i=1}^{4} MF\left(\bar{x}_i^{step=j+1}\right)}{4}\right|}$$

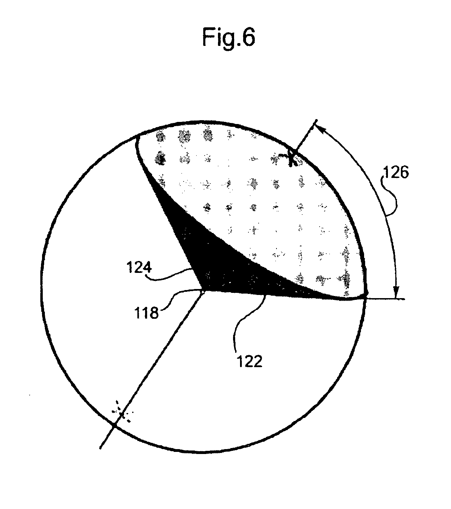

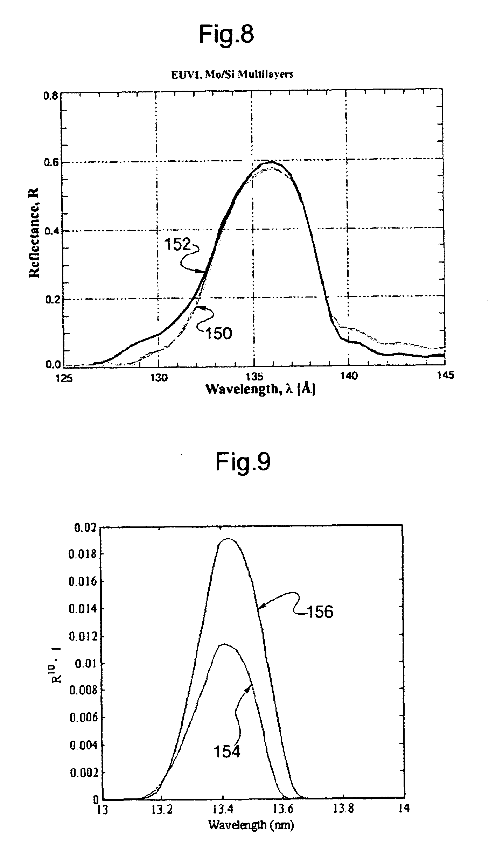

In figure 6 is represented a schematic cone inside the spherical domain 120 of figure 8 in which a versor 124 and an angle 126 are depicted.

When the time interval into which the above disclosed calculation steps are performed is finished, a comparison is made between the merit functions of the structures thus obtained and the structure whose merit function is the more enhanced is selected as the best one.

In this way, differently form a pure genetic algorithm, it is possible to deeply explore some specific domain areas. The method allows also the optimization of interlayers, when these are introduced between the two main materials; they are seen as added layers with different optical constants. More generally, the method may optimize whatever structure.

## Examples

In the following examples are presented. In all examples, the structures are optimized for a 10° incidence angle between the normal to the front surface of the first layer 10a, 10a' and the direction of the light from the source. In all the examples, a 5 Å of multilayers interface roughness has been taken into account.

## Example 1

Aperiodic multilayer stacks 2 of type shown in figures 1 (without the interlayers 8) made of alternating layers of Molybdenum and amorphous Silicon with a $Mo/RuO_2$ capping layer have been compared with a standard periodic multilayer structure made of the same materials.

In table I are reported the thicknesses of the layers.

Table 1

| *Structure according to embodiment of figure 1(without interlayers)* | | |
|---|---|---|
| Capping layer | $RuO_2$/Mo | 23 A / 20 Å |
| | amorphous Silicon layer minimum | 24.1 Å |
| | amorphous Silicon layer maximum | 42.9Å |
| | Molybdenum layer minimum | 26.8 Å |
| | Molybdenum layer maximum | 35.5 Å |

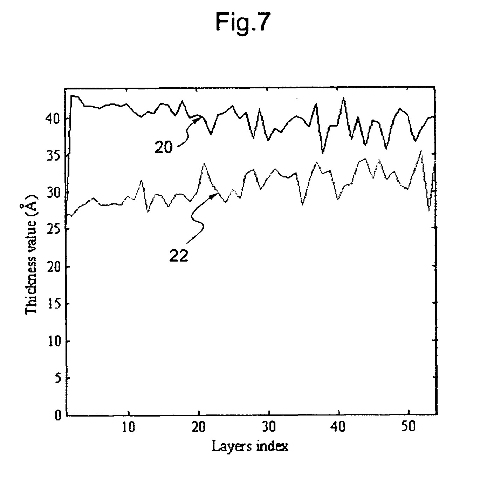

Figure 7 shown the curves of the thicknesses of the layers as function of the layer index, which indicates the layers (capping layers omitted) with an increasing number from the most external to the internal one: a first curve 20 is related to the layer of the first material 4, Silicon, a second curve 22 is related to the layer of the second material 6, Molybdenum. As shown, thicknesses and periods are randomly distributed, being very far from solution in a round of the periodic multilayer.

The multilayer structure is optimized to provide maximum reflectance in a photolithographic system comprising N=10 mirrors. The optimization is made in order to match the spectrum of one of the possible sources of an EUV lithographic system, i.e. the Sn laser produced plasma, according to the $\int R(\lambda)^N * I(\lambda)d\lambda$, merit function previously introduced.

The reflectivity of the structure of table 1 has been compared with that of a standard periodic structure of the type reported in table 2.

Table 2

| *Periodic structure (period of 69.8 Å. $\Gamma$ of 0.6)* | | |
|---|---|---|
| Capping layer | $RuO_2$/Mo | 23 A / 20 Å |
| | amorphous Silicon layer | 41.9 Å |
| | Molybdenum layer | 27.9 Å |

Assuming, for instance, a projection system with ten subsequent reflections, an improvement of the efficiency up to 79%, corresponding to a multiplication factor of 1.79 with respect to the system of table 2, has been computed.

Figure 8 shows experimental results obtained by the measure of two structures realized according to embodiment of figure 1 and table 2. A first curve 150 is related to a periodic structure as the one of table 2, a second curve 152 is related to a randomly aperiodic structure as the one of table 1.

Figure 9 shows a comparison between structures of table 1 and 2 for a projection system with ten subsequent reflections. A first curve 154 is related to the periodic structure of table 2, a second curve 156 is related to the randomly aperiodic structrure of table 1. It is clearly visible the improvement of the efficiency up to 79% above disclosed.

Example 2

The same comparison of example 1 with the standard periodic structure of table 2 has been made using stacks of the type shown in figure 2 (without the interlayers 8'), made of alternating layers of Molybdenum and amorphous Silicon with a Mo/RuO$_2$ capping layer in which only last layers underneath the capping layer are varied, according to parameters presented in table 3.

Table 3

| *Structure according to embodiment of figure 2 (without interlayers, period of 70.2 Å)* | | |
|---|---|---|
| Capping layer | RuO$_2$/MO | 23 Å / 20 Å |
| Pre-caplayer | amorphous Silicon/ Molybdenum | 23.3 Å / 27 Å |
| | amorphous Silicon layer | 41.1 Å |
| | Molybdenum layer | 29.1 Å |

In a projection system with ten subsequent reflections, an improvement of the efficiency up to 77%, corresponding to a multiplication factor 1.77 with respect to the system of table 2, has been computed.

Example 3

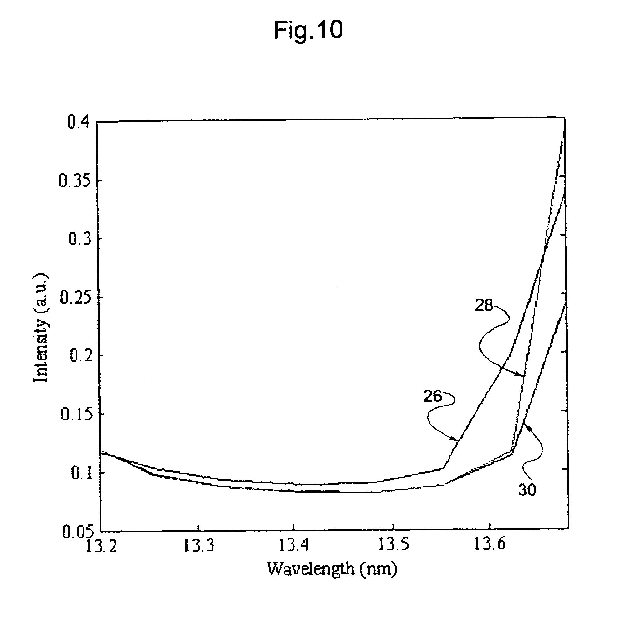

Different comparisons have been made with reference to the structures disclosed in tables 1,2 and 3. For each of the structure, each intensity value of a node 24, 24' (see figures 1 and 2) out of the capping layer has been calculated for a wide spectral wavelength corresponding to about the Full Width Half Maximum of the multilayer reflectance. Results are reported in figure 10: a first curve 26 is related to the structure of table 2, a second curve 28 is related to the structure of table 3 and a third curve 30 is related to the structure of table 1. It is evident that value related to the aperiodic stack of table 1 is always lower then the one of the periodic standard multilayer, demonstrating that this is the optimum solution. The value of the aperiodic stack with pre-caplayer is lower almost everywhere, and in any case the integral of the curve is again lower that the one corresponding to the periodic standard structure.

Example 4

Some tests have been performed to compare the performances sensitivity to layer thickness errors during deposition of aperiodic structures with respect to standard periodic ones. Structures presented in tables 1, 2 and 3 have been considered for comparison. In order to do so, a mean percentage of reflected spectrum (calculated as $100*\int R(\lambda)^{10}*I(\lambda)d\lambda,/\int I(\lambda)d\lambda$) has been evaluated for 3000 structures, obtained by a variation of the three structures: each layer thickness has been randomly varied inside a maximum interval of $\pm 0.01$nm (which is a typical error during a deposition process), with a uniform probability distribution. In table 4 statistical data for the three types of structures are reported.

Table 4

| | *Mean percentage of reflected spectrum* | *Standard deviation* |
|---|---|---|
| *Structure according to table 1* | 0.4108 | 0.00106 |
| *Structure according to table 3* | 0.4063 | 0.00120 |
| *Structure according to table 2 (periodic)* | 0.2319 | 0.00211 |

Statistical analysis confirms that structures according to table 1 are more stable to random layer thickness variation then both standard periodic and aperiodic with pre-caplayer, and that the aperiodic with pre-caplayer are more stable then standard periodic ones.

Example 5

A stack according to embodiment of figure 1 has been optimized to provide maximum reflectance in a photo-lithographic system (see table 5).
In table 5 are reported the thicknesses of the layers.

Table 5

| Structure according to embodiment of figure 1 | | |
|---|---|---|
| Capping layer | RuO$_2$/B$_4$C | 23 Å / 20 Å |
| | amorphous Silicon layer minimum | 19 Å |
| | amorphous Silicon layer maximum | 40 Å |
| | B$_4$C interlayer | 2.5 Å |
| | Molybdenum layer minimum | 25 Å |
| | Molybdenum layer maximum | 30 Å |
| | B$_4$C interlayer | 4 Å |

Standing wave field at wavelength 13.4 nm has been considered (actually is the one reported in figure 1). Comparison with a standard periodic MoB$_4$C/a-Si multilayer with a capping layer of RuO$_2$/B$_4$C has been made.

In table 6 are reported the thicknesses of the layers of the standard periodic MoB$_4$C/a-Si multilayer with a capping layer of RuO$_2$B$_4$C.

Table 6

| Periodic structure (period of 69.8 Å, $\Gamma$ of 0.6) | | |
|---|---|---|
| Capping layer | RuO$_2$/B$_4$C | 23Å/20Å |
| | amorphous Silicon layer | 38.6 Å |
| | B$_4$C interlayer | 2.5 Å |
| | Molybdenum layer | 24.7 Å |
| | B$_4$C interlayer | 4.0 Å |

Assuming, for instance, a projection system with ten subsequent reflections and a Sn laser plasma source, an improvement of the efficiency up to 115%, corresponding to a multiplication factor 2.15 with respect to the system of table 6, has been computed.

A comparison between the standing wave corresponding to the multilayer with RuO$_2$ /Mo capping layer of example 1 (see table 1) and the one of this example (see table 5) shows that in the first case the position of the node in the capping layer is inside the Mo layer, while in the second one is in the RuO$_2$ layer (as in figure 1). This is due to the fact that at 13.4 nm absorption coefficient of B$_4$C is lower then the Mo one, which is closer to the one of RuO$_2$.

Example 6

A comparison similar to that of example 5 has been made using stacks of the type shows in figure 2.

In table 6 are reported the thicknesses of the layers.

Table 6

| Structure according to embodiment of figure 2 (period of 70.3 Å) | | |
|---|---|---|
| Capping layer | RuO$_2$/B$_4$C | 23 Å / 20 Å |
| Pre capping layer | a-Si/B$_4$C/ MoB$_4$C | 19 Å/ 2.5 Å/ 24.75 Å/ 4 Å |
| | amorphous Silicon layer | 35.3 Å |
| | B$_4$C interlayer | 2.5 Å |
| | Molybdenum layer | 28.5 Å |
| | B$_4$C layer | 4.0 Å |

Assuming, for instance, a projection system with ten subsequent reflections, an improvement of 110% with respect to the system of table 6 is obtained.

Example 7

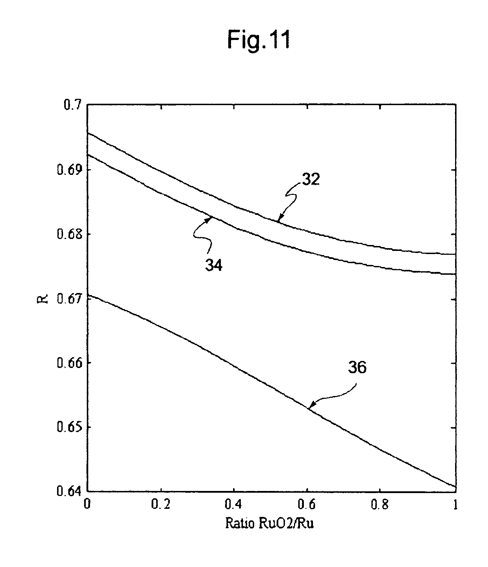

In order to prove the less sensitivity of the performances to capping layer oxidation, the following calculation has been performed for structure of table 1 and 3 to be compared with the standard periodic structure of table 2: the last layer of the capping layer (i.e. the $RuO_2$ in the tables) has been initially considered not oxidized, and then partially oxidized up to be totally oxidized. Peak reflectivity has been calculated at 13.4 nm in all cases. Results obtained are reported in figure 11: a first curve 32 refers to the structure of table 1, a second curve 34 refers to the structure of table 3 and a third curve 36 refers to the standard periodic structure of table 2. It is clear that the reflectivity of aperiodic structures is less affected by the growing of the oxide.

Example 8

The design method used for the search of the aperiodic random solution considers the amount of roughness at interfaces. This fact thus leads to solutions that take into account advanced manufacturing aspects and physical properties of practical multilayer structures. To show how this is relevant, a test has been performed.

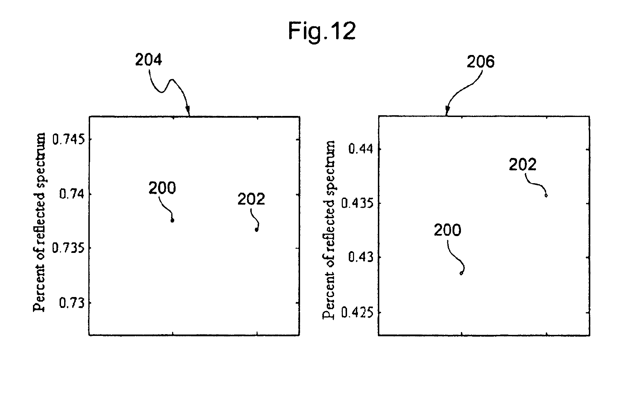

It has been used the merit function $\int R(\lambda)^{10} * I(\lambda) d\lambda$ and it has been searched for the aperiodic best structure following the steps above described. In figure 12 there are shown two graphs which compare the percentage of reflected spectrum of a first structure 200 found by the method assuming an interface roughness equal to zero, and of a second structure 202 found assuming an interface roughness of 5 Å. The percentage of reflected spectrum has been calculated as $100 * \int R(\lambda)^{10} * I(\lambda) d\lambda / \int I(\lambda) d\lambda$. In a first graph 204, the percentage of reflected spectrum of structure 200 is compared with the one of the second structure 202, but calculated without roughness; in a second graph 206 the percentage of reflected spectrum of the first structure 200 is calculated adding a roughness of 5Å (as would be more realistic in case of a real deposit) and compared with the one of structure 202. As shown in 206, in this more realistic case in which both structures have a 5 Å roughness at interfaces, structure 202 shows better performances. If the search did not carry on by adding this roughness at interfaces, ideal best solution would have found to be structure 200, as demonstrated in 204; but, a real deposited multilayer according to design 200 would not preserve its supremacy over 202. The second structure 202 is therefore a better solution as the real physical properties of the interfaces are taken into account during mathematical search.

Clearly, the principle of the invention remaining the same, the embodiments and the details of construction can be varied widely from what has been described and illustrated purely by way of non-limiting example, without departing from the scope of protection of the present invention as defined in the attached claims.

**Claims**

1.    A reflective coating for reflecting EUV radiation, wherein said coating includes an aperiodic multilayer reflective structure (2, 2') comprising a plurality of alternating layers of a first (4,4a,4') and a second (6,6a,6') material, and a capping layer (10, 10') covering said structure, wherein the thickness of said alternating layers varies from periodicity in at least a portion of said structure (2, 2') in such a way as that a standing wave field distribution generated during reflection of a working wavelength in the EUV spectral range has a standing wave anti-node (15) at the top of said structure, whose position with respect to said capping layer is shifted as compared to a periodic multilayer reflective structure, said coating being **characterized in that** the standing wave field distribution is shifted in such a way has to have a standing wave node in the inside of the capping layer.

2.    The coating according to claim 1, in which the thickness of said alternating layers randomly varies in the whole structure (2, 2') in order to maximize total photon flux over a full spectral range of a given source.

3.    The coating according to claim 1, in which the thickness of said alternating layers varies from periodicity in the first pair of layers among said plurality of alternating layers, which is underneath said capping layer.

4.    The coating according to any of claims 1 to 3, comprising at least one interlayer (8, 8') of a third material interposed between said first (4, 4') and second (6, 6') material.

5.    The coating according to any of the preceding claims, in which said first (4, 4') and second (6, 6') material are selected from the group consisting of amorphous Silicon, Molybdenum, Beryllium, Ruthenium, Rhodium, Strontium and their compounds.

6.    The coating according to claim 4, in which said third material is selected from the group consisting of Boron Carbide, Carbon, Silicon Carbide and their compounds.

7. The coating according to any of the preceding claims, in which said capping layer (10, 10') is made of a material selected from the group consisting of Ruthenium, Rhodium, Zirconium, Palladium, Platinum, Iridium, Osmium, Molybdenum, Boron Carbide, Silicon Carbide and their compounds.

8. The coating according to any of the preceding claims, in which said capping layer (10, 10') comprise at least a first layer (10a) and a second layer (10b) made of different materials.

9. The coating according to claim 8, in which said first layer (10a) is made of a material selected from the group consisting of Ruthenium, Rhodium, Zirconium, Palladium, Platinum, Iridium, Osmium and their compounds.

10. The coating according to claim 8, in which said second layer (10b) is made of a material selected from the group consisting of Boron Carbide, Carbon, Silicon Carbide, Molybdenum and their compounds.

11. A photolithographic apparatus comprising a reflective coating as defined in any of the claims 1 to 10.

12. A method for designing a reflective coating, said method comprising the steps of:

- defining a multilayer reflective structure (2, 2') comprising a plurality of alternating layers of a first (4, 4') and a second (6, 6') material, and a capping layer (10, 10') covering said structure, and
- varying the thickness of said alternating layers from periodicity in at least a portion of said structure in such a way as that a standing wave field distribution generated during reflection of a working wavelength in the EUV spectral range has a standing wave anti-node (15) at the top of said structure, whose position with respect to said capping layer is shifted as compared to a periodic multilayer reflective structure,

said method being **characterized in that** the standing wave field distribution is shifted in such a way as to have a standing wave node in the inside of the capping layer.

13. The method according to claim 12, wherein said multilayer reflective structure is designed such that the thickness of said alternating layers randomly varies in the whole structure (2, 2'), said method comprising the steps of:

a) define a predetermined time interval;
b) define a first family of periodic multilayer structures (for example

$$\left\{ \bar{x}_1^{\,step=0}, \bar{x}_2^{\,step=0}, \bar{x}_3^{\,step=0}, \bar{x}_4^{\,step=0} \right\} );$$

c) calculate a first merit function (for example $\int R(\lambda)^N * I(\lambda) d\lambda$ ) for each structure of said first family of structures;
d) define a first predetermined domain for each structure of said first family of structures;
e) apply at least one random mutation to each structure of said first family of structures inside the associated first predetermined domain;
f) calculate a second merit function (for example $\int R(\lambda)^N * I(\lambda) d\lambda$ ) for said at least one mutation;
g) compare each of said first merit functions with the second merit function of the associated at least one mutation;
h) if said second merit function is enhanced with respect to the associated first merit function, substitute the at least one mutation for the structure of the first family and define a second predetermined domain for said at least one mutation, otherwise, maintain said structure of the first family inside the corresponding first domain;
i) calculate a mean value of the merit functions of the first family of structures or mutations present in each first or second domain;
l) define a predetermined threshold value to said mean value;
m) for each first family of structures or mutations present in each first or second domain whose merit function is enhanced of said predetermined threshold with respect to said mean value, substitute a predetermined third domain to the predetermined first or second domain until the corresponding merit function is enhanced of said predetermined threshold;
n) repeat step from d) to m) until said predetermined time interval has lapsed;
o) compare the merit functions of the first family of structures or mutations present in each first domain and select the structure or mutation whose merit function is the more enhanced.

14. The method according to claim 13, wherein said first predetermined domain is spherical.

15. The method according to claim 13 or 14, wherein said second predetermined domain is spherical.

16. The method according to any of the claim 13 to 15, wherein said third predetermined domain is conical.

17. The method according to any of the claim 13 to 16, wherein said predetermined time interval is of eight hour.

18. The method according to any of the claim 13 to 17, wherein said first merit function takes into account roughness and interdiffusion.

19. The method according to any of the claim 13 to 18, wherein said second merit function takes into account roughness and interdiffusion.

**Patentansprüche**

1. Reflektierende Beschichtung zum Reflektieren von EUV-Strahlung, wobei die Beschichtung eine aperiodische mehrschichtige reflektierende Struktur (2, 2') einschließt, umfassend eine Vielzahl von alternierenden Schichten eines ersten (4, 4a, 4') und eines zweiten (6, 6a, 6') Materials und eine Deckschicht (10, 10'), welche die Struktur bedeckt, wobei die Dicke der alternierenden Schichten von der Periodizität in mindestens einem Abschnitt der Struktur (2, 2') in einer solchen Weise variiert, daß eine Feldverteilung einer stehenden Welle, erzeugt während der Reflexion einer Arbeitswellenlänge in dem EUV Spektralbereich, eine Anti-Node (15) einer stehenden Welle an der Spitze der Struktur aufweist, deren Position bezüglich der Deckschicht verschoben ist, verglichen zu einer periodischen mehrschichtigen reflektierenden Struktur, wobei die Beschichtung **dadurch gekennzeichnet ist, daß** die Feldverteilung der stehenden Welle in einer solchen Weise verschoben ist, daß sie einen Knoten einer stehenden Welle innerhalb der Deckschicht aufweist.

2. Beschichtung gemäß Anspruch 1, worin die Dicke der alternierenden Schichten statistisch in der gesamten Struktur (2, 2') variiert, um den Gesamtphotonenfluß über einen vollen Spektralbereich einer gegebenen Quelle zu maximieren.

3. Beschichtung gemäß Anspruch 1, worin die Dicke der alternierenden Schichten von der Periodizität in dem ersten Paar von Schichten unter der Vielzahl von alternierenden Schichten, welche unter der Deckschicht ist, variiert.

4. Beschichtung gemäß einem der Ansprüche 1 bis 3, umfassend mindestens eine Zwischenschicht (8, 8') eines dritten Materials, zwischengelegt zwischen das erste (4,4') und zweite (6, 6') Material.

5. Beschichtung gemäß einem der vorhergehenden Ansprüche, worin das erste (4, 4') und das zweite (6, 6') Material aus der Gruppe ausgewählt sind, bestehend aus amorphem Silicium, Molybdän, Beryllium, Ruthenium, Rhodium, Strontium und deren Verbindungen.

6. Beschichtung gemäß Anspruch 4, worin das dritte Material aus der Gruppe ausgewählt ist, bestehend aus Borcarbid, Kohlenstoff, Siliciumcarbid und deren Verbindungen.

7. Beschichtung gemäß einem der vorhergehenden Ansprüche, worin die Deckschicht (10, 10') aus einem Material ist, ausgewählt aus der Gruppe, bestehend aus Ruthenium, Rhodium, Zirkonium, Palladium, Platin, Iridium, Osmium, Molybdän, Borcarbid, Siliciumcarbid und deren Verbindungen.

8. Beschichtung gemäß einem der vorhergehenden Ansprüche, worin die Deckschicht (10, 10') mindestens eine erste Schicht (10a) und eine zweite Schicht (10b), welche aus unterschiedlichen Materialien sind, umfaßt.

9. Beschichtung gemäß Anspruch 8, worin die erste Schicht (10a) aus einem Material ist, ausgewählt aus der Gruppe, bestehend aus Ruthenium, Rhodium, Zirkonium, Palladium, Platin, Iridium, Osmium und deren Verbindungen.

10. Beschichtung gemäß Anspruch 8, worin die zweite Schicht (10b) aus einem Material ist, ausgewählt aus der Gruppe, bestehend aus Borcarbid, Kohlenstoff, Siliciumcarbid, Molybdän und deren Verbindungen.

11. Photolithographische Vorrichtung, umfassend eine reflektierende Beschichtung, wie in einem der Ansprüche 1 bis 10 definiert.

12. Verfahren zum Gestalten einer reflektierenden Beschichtung, wobei das Verfahren die Schritte umfaßt:

- das Definieren einer mehrschichtigen reflektierenden Struktur (2, 2'), umfassend eine Vielzahl an alternierenden Schichten eines ersten, (4, 4') und eines zweiten (6, 6') Materials und einer Deckschicht (10, 10'), welche die Struktur bedeckt, und
- das Variieren der Dicke der alternierenden Schichten von der Periodizität in mindestens einem Abschnitt der Struktur in einer solchen Weise, daß eine Feldverteilung einer stehenden Welle, erzeugt während der Reflexion einer Arbeitswellenlänge in dem EUV-Spektralbereich, eine Anti-Node (15) einer stehenden Welle an der Spitze der Struktur aufweist, deren Position bezüglich der Deckschicht verschoben ist, verglichen zu einer periodischen mehrschichtigen reflektierenden Struktur,
wobei das Verfahren **dadurch gekennzeichnet ist, daß** die Feldverteilung einer stehenden Welle in einer solchen Weise verschoben ist, daß sie einen Knoten einer stehenden Welle innerhalb der Deckschicht aufweist.

13. Verfahren gemäß Anspruch 12, wobei die mehrschichtige reflektierende Struktur derart gestaltet ist, daß die Dicke der alternierenden Schichten statistisch in der gesamten Struktur (2, 2') variiert, wobei das Verfahren die Schritte umfaßt:

a) das Definieren eines vorbestimmten Zeitintervalls,
b) das Definieren einer ersten Familie an periodischen mehrschichtigen Strukturen (beispielsweise

$$\left\{ \overline{x}_1^{\;step=0}, \overline{x}_2^{\;step=0}, \overline{x}_3^{\;step=0}, \overline{x}_4^{\;step=0} \right\});$$

c) das Berechnen einer ersten Bewertungsfunktion (zum Beispiel $\int R(\lambda)^N * I(\lambda)d\lambda$) für jede Struktur der ersten Familie an Strukturen,
d) das Definieren einer ersten vorbestimmten Domäne für jede Struktur der ersten Familie an Strukturen,
e) das Anwenden mindestens einer statistischen Mutation an jede Struktur der ersten Familie an Strukturen in der verknüpften ersten vorbestimmten Domäne,
f) das Berechnen einer zweiten Bewertungsfunktion (beispielsweise $\int R(\lambda)^N * I(\lambda)d\lambda$) für die mindestens eine Mutation,
g) das Vergleichen von jeder der ersten Bewertungsfunktionen mit der zweiten Bewertungsfunktion der verknüpften mindestens einen Mutation,
h) wenn die zweite Bewertungsfunktion bezüglich der verknüpften ersten Bewertungsfunktion vergrößert ist, das Substituieren der mindestens einen Mutation für die Struktur der ersten Familie und das Definieren einer zweiten vorbestimmten Domäne für die mindestens eine Mutation, andernfalls Beibehalten der Struktur der ersten Familie in der entsprechenden ersten Domäne,
i) das Berechnen eines Mittelwerts der Bewertungsfunktionen der ersten Familie an Strukturen oder Mutationen, die in jeweils der ersten oder zweiten Domäne vorliegen,
l) das Definieren eines vorbestimmten Schwellenwerts bezüglich des Mittelwerts,
m) für jede erste Familie an Strukturen oder Mutationen vorliegend in jeweils der ersten oder zweiten Domäne deren Bewertungsfunktion bezüglich der vorbestimmten Schwelle mit Bezug auf den Mittelwert vergrößert ist, das Substituieren einer vorbestimmten dritten Domäne zu der vorbestimmten ersten oder zweiten Domäne, bis die entsprechende Bewertungsfunktion bezüglich der vorbestimmten Schwelle vergrößert ist,
n) Wiederholen des Schritts von d) bis m), bis der vorbestimmte Zeitintervall verstrichen ist,
o) das Vergleichen der Bewertungsfunktionen der ersten Familie an Strukturen oder Mutationen, die in jeweils der ersten Domäne vorliegen, und Auswählen der Struktur der Mutation,deren Bewertungsfunktion die am meisten vergrößerte ist.

14. Verfahren gemäß Anspruch 13, wobei die erste vorbestimmte Domäne sphärisch ist.

15. Verfahren gemäß Anspruch 13 oder 14, wobei die zweite vorbestimmte Domäne sphärisch ist.

**16.** Verfahren gemäß einem der Ansprüche 13 bis 15, wobei die dritte vorbestimmte Domäne konisch ist.

**17.** Verfahren gemäß einem der Ansprüche 13 bis 16, wobei das vorbestimmte Zeitintervall acht Stunden beträgt.

**18.** Verfahren gemäß einem der Ansprüche 13 bis 17, wobei die erste Bewertungsfunktion die Rauhigkeit und Interdiffusion berücksichtigt.

**19.** Verfahren gemäß einem der Ansprüche 13 bis 18, wobei die zweite Bewertungsfunktion Rauhigkeit und Interdiffusion berücksichtigt.

**Revendications**

**1.** Revêtement réfléchissant destiné à réfléchir un rayonnement UVE, dans lequel ledit revêtement comprend une structure réfléchissante multicouche apériodique (2, 2') constituée d'une pluralité de couches alternées d'un premier (4; 4a, 4') et d'un deuxième matériau (6; 6a, 6') et d'une couche de recouvrement (10, 10') recouvrant ladite structure, dans lequel l'épaisseur desdites couches alternées varie par rapport à la périodicité dans au moins une partie de ladite structure (2, 2'), d'une manière telle qu'une répartition de champ d'ondes stationnaires générée pendant la réflexion d'une longueur d'onde de travail dans la gamme spectrale UVE présente un ventre (15) d'onde stationnaire en haut de ladite structure, dont la position par rapport à ladite couche de recouvrement est décalée comparé à une structure réfléchissante multicouche périodique, ledit revêtement étant **caractérisé en ce que** la répartition de champ d'ondes stationnaires est décalée de manière à présenter un noeud d'ondes stationnaires à l'intérieur de la couche de recouvrement.

**2.** Revêtement selon la revendication 1, dans lequel l'épaisseur desdites couches alternées varie de façon aléatoire dans l'ensemble de la structure (2, 2') afin de maximiser le flux photonique total sur une gamme spectrale complète d'une source donnée.

**3.** Revêtement selon la revendication 1, dans lequel l'épaisseur desdites couches alternées varie par rapport à la périodicité dans la première paire de couches parmi ladite pluralité de couches alternées, qui se trouve sous ladite couche de recouvrement.

**4.** Revêtement selon l'une quelconque des revendications 1 à 3, comprenant au moins une couche intermédiaire (8, 8') d'un troisième matériau, intercalée entre ledit premier (4, 4') et deuxième (6, 6') matériau.

**5.** Revêtement selon l'une quelconque des revendications précédentes, dans lequel ledit premier (4, 4') et deuxième (6, 6') matériau sont sélectionnés dans le groupe comprenant le silicium amorphe, le molybdène, le béryllium, le ruthénium, le rhodium, le strontium et leurs composés.

**6.** Revêtement selon la revendication 4, dans lequel ledit troisième matériau est sélectionné dans le groupe comprenant le carbure de bore, le carbone, le carbure de silicium et leurs composés.

**7.** Revêtement selon l'une quelconque des revendications précédentes, dans lequel ladite couche de recouvrement (10, 10') est formée d'un matériau sélectionné dans le groupe comprenant le ruthénium, le rhodium, le zirconium, le palladium, le platine, l'iridium, l'osmium, le molybdène, le carbure de bore, le carbure de silicium et leurs composés.

**8.** Revêtement selon l'une quelconque des revendications précédentes, dans lequel ladite couche de recouvrement (10, 10') est constituée d'au moins une première couche (10a) et d'une deuxième couche (10b) formées de matériaux différents.

**9.** Revêtement selon la revendication 8, dans lequel ladite première couche (10a) est formée d'un matériau sélectionné dans le groupe comprenant le ruthénium, le rhodium, le zirconium, le palladium, le platine, l'iridium, l'osmium et leurs composés.

**10.** Revêtement selon la revendication 8, dans lequel ladite deuxième couche (10b) est formée d'un matériau sélectionné dans le groupe comprenant le carbure de bore, le carbone, le carbure de silicium, le molybdène et leurs composés.

**11.** Dispositif photolithographique comportant un revêtement réfléchissant tel que défini dans l'une quelconque des revendications 1 à 10.

12. Procédé pour concevoir un revêtement réfléchissant, ledit procédé comprenant les étapes suivantes :

- définition d'une structure réfléchissante multicouche (2, 2') constituée d'une pluralité de couches alternées d'un premier (4, 4') et d'un deuxième matériau (6, 6') et d'une couche de recouvrement (10, 10') recouvrant ladite structure, et
- variation de l'épaisseur desdites couches alternées par rapport à la périodicité dans au moins une partie de ladite structure, d'une manière telle qu'une répartition de champ d'ondes stationnaires générée pendant la réflexion d'une longueur d'onde de travail dans la gamme spectrale UVE présente un ventre (15) d'onde stationnaire en haut de ladite structure, dont la position par rapport à ladite couche de recouvrement est décalée comparé à une structure réfléchissante multicouche périodique,
- ledit procédé étant **caractérisé en ce que** la répartition de champ d'ondes stationnaires est décalée de manière à présenter un noeud d'ondes stationnaires à l'intérieur de la couche de recouvrement.

13. Procédé selon la revendication 12, selon lequel ladite structure réfléchissante multicouche est conçue de manière à ce que l'épaisseur desdites couches alternées varie de façon aléatoire dans l'ensemble de la structure (2, 2'), ledit procédé comprenant les étapes suivantes :

a) définition d'un intervalle de temps prédéterminé;
b) définition d'une première famille de structures multicouches périodiques (par exemple

$$\left\{ X_1^{\_pas=0}, X_2^{\_pas=0}, X_3^{\_pas=0}, X_4^{\_pas=0} \right\} )$$

c) calcul d'une première fonction de mérite (par exemple $\int R(\lambda)^N * I(\lambda) d\lambda$ ) pour chaque structure de ladite première famille de structures;
d) définition d'un premier domaine prédéterminé pour chaque structure de ladite première famille de structures;
e) application d'au moins une mutation aléatoire à chaque structure de ladite première famille de structures à l'intérieur du premier domaine prédéterminé associé;
f) calcul d'une deuxième fonction de mérite (par exemple $\int R(\lambda)^N * I(\lambda) d\lambda$ pour ladite mutation, au nombre d'au moins une;
g) comparaison de chacune desdites premières fonctions de mérite avec la deuxième fonction de mérite de la mutation associée, au nombre d'au moins une;
h) si ladite deuxième fonction de mérite est augmentée par rapport à la première fonction de mérite associée, substitution de la mutation, au nombre d'au moins une, pour la structure de la première famille, et définition d'un deuxième domaine prédéterminé pour ladite mutation, au nombre d'au moins une, sinon maintien de ladite structure de la première famille à l'intérieur du premier domaine correspondant;
i) calcul d'une valeur moyenne des fonctions de mérite de la première famille de structures ou de mutations présentes dans chaque premier ou deuxième domaine;
l) définition d'une valeur seuil prédéterminée pour ladite valeur moyenne;
m) pour chaque première famille de structures ou de mutations présentes dans chaque premier ou deuxième domaine dont la fonction de mérite est augmentée avec ledit seuil prédéterminé par rapport à ladite valeur moyenne, substitution d'un troisième domaine prédéterminé au premier ou deuxième domaine prédéterminé, jusqu'à ce que la fonction de mérite correspondante soit augmentée avec ledit seuil prédéterminé;
n) répétition des étapes d) à m), jusqu'à ce que ledit intervalle de temps prédéterminé se soit écoulé;
o) comparaison des fonctions de mérite de la première famille de structures ou de mutations présentes dans chaque premier domaine et sélection de la structure ou de la mutation dont la fonction de mérite est augmentée le plus.

14. Procédé selon la revendication 13, selon lequel ledit premier domaine prédéterminé est sphérique.

15. Procédé selon la revendication 13 ou 14, selon lequel ledit deuxième domaine prédéterminé est sphérique.

16. Procédé selon l'une quelconque des revendications 13 à 15, selon lequel ledit troisième domaine prédéterminé est conique.

17. Procédé selon l'une quelconque des revendications 13 à 16, selon lequel ledit intervalle de temps prédéterminé est de huit heures.

18. Procédé selon l'une quelconque des revendications 13 à 17, selon lequel ladite première fonction de mérite prend en compte la rugosité et l'interdiffusion.

19. Procédé selon l'une quelconque des revendications 13 à 18, selon lequel ladite deuxième fonction de mérite prend en compte la rugosité et l'interdiffusion.

## Fig.1

## Fig.2

# Fig.3

## Fig.4

## Fig.5

## Fig.6

# Fig.7

# Fig.8

EUVL Mo/Si Multilayers

# Fig.9

## Fig.10

# Fig.11

# Fig.12

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- EP 1065532 A2
- US 6724462 B1
- US 6780496 B2
- WO 2006066563 A
- US 2004253426 A
- US 2005031071 A
- US 2006066940 A

### Non-patent literature cited in the description

- **PAUL B. MIRKARIMI ; SASA BAJT et al.** Mo/Si and Mo/Be multilayer thin films on Zerodur substrates for extreme-ultraviolet lithography. *Applied Optics,* 2000, vol. 39 (10), 1617-1625
- Improved reflectance and stability of Mo/Si multilayers. **SASA BAJT ; JENNIFER B. ALAMEDA et al.** Optical Engineering. 2002, vol. 41, 1797-1804
- **UNDERWOOD et al.** *Applied Optics,* 1993, vol. 32, 6985
- Layer-by-layer design method for soft-X-rays multi layers. *Applied Optics,* 1992, vol. 31 (10), 1622-1630
- **M. SINGH ; J. M. BRAAT.** Design of multilayer extreme - ultraviolet mirrors for enhanced reflectivity. *Applied Optics,* 2000, vol. 39 (13), 2189
- **M. SINGH ; J. J. M. BRAAT.** Capping layers for extreme ultraviolet multilayer interference coatings. *Opt. Lett.,* 2001, vol. 26, 259-261
- **SASA BAJT ; ZU RONG DAI et al.** Oxidation resistance of Ru-capped EUV multilayers. *Proc. SPIE,* 2005, vol. 5751, 118-127
- **SASA BAJT ; HENRY N. CHAPMAN.** Design and performance of capping layers for extreme-ultraviolet multilayer mirrors. *Applied Optics,* 2003, vol. 42 (28), 5750-5758
- *Applied Optics,* 01 July 1990, vol. 29 (19), 2876-2893
- **ZHANSHAN WANG et al.** Design, fabrication, and characterization of broadband multilayer mirrors for EUV optics at normal incidence. *Soft X-ray and EUV imaging systems, Proceedings of SPIE,* 01 November 2000, vol. 4146, 83-90